# EUROPÄISCHE PATENTSCHRIFT

(11) **EP 3 320 124 B1**
(45) Veröffentlichungstag und Bekanntmachung des Hinweises auf die Patenterteilung: **03.04.2019**
(21) Anmeldenummer: 16751457.9
(22) Anmeldetag: 05.07.2016
(51) Int. Cl.: C23C 14/34, C23C 14/16, F16C 17/02, F16C 33/12

(54) **GLEITLAGERELEMENT**
SLIDING BEARING ELEMENT
ÉLÉMENT PALIER ANTIFRICTION

(30) Priorität: 06.07.2015 AT 505822015
(43) Veröffentlichungstag der Anmeldung: 16.05.2018
(73) Patentinhaber: Miba Gleitlager Austria GmbH, 4663 Laakirchen (AT)
(72) Erfinder: NAGL, Johann, 4651 Stadl-Paura (AT); ÜBLEIS, Christian, 4616 Weißkirchen a. d. Traun (AT)
(74) Vertreter: Burger, Hannes
(86) Internationale Anmeldenummer: PCT/AT2016/050241
(87) Internationale Veröffentlichungsnummer: WO 2017/004646

(56) Entgegenhaltungen:
- EP-A1- 1 705 259
- WO-A2-2010/005983

## Beschreibung

Die Erfindung betrifft ein Gleitlagerelement umfassend eine Stützschicht und eine Gleitschicht, wobei die Gleitschicht aus Silber oder aus Silber mit einem Maximalgehalt an weiteren Metallen von 5 Gew.-%, ausgewählt aus einer Gruppe bestehend aus Cu, Sb, Mo, Co, besteht, wobei die Gleitschicht eine Mikrostruktur mit Körnern aufweist und eine Gleitschichtdicke hat.

Weiter betrifft die Erfindung ein Verfahren zur Herstellung eines Gleitlagerelements umfassend eine Stützschicht und eine, eine Mikrostruktur mit Körnern aufweisende Gleitschicht, wobei die Gleitschicht mit einer Gleitschichtdicke aus Silber oder aus Silber mit einem Maximalgehalt an weiteren Metallen von 5 Gew.-% hergestellt wird.

Der Trend zu erhöhten Leistungsdichten bei der Entwicklung von Motor- und Triebwerksgenerationen stellt zunehmende Herausforderungen an die Entwicklung verschleißfester Laufschichten. Oft ist diese Verschleißfestigkeit gekoppelt an die Forderung nach hoher Schmutzverträglichkeit und gutmütigem Einlaufverhalten. Ein weiterer Trend in der Material- und Verfahrensentwicklung ist die Abkehr von umweltgefährdenden Materialien oder Prozesse, wobei jedoch die tribologischen und mechanischen Eigenschaften bestehender herkömmlicher Gleitlagermaterialien beibehalten oder übertroffen werden sollen.

Um diesen Entwicklungen nachzukommen werden in der Gleitlagertechnik die erforderlichen Eigenschaften eines Gleitlagers auf mehrere Schichten aufgeteilt. Dadurch können die einzelnen Schichten hinsichtlich ihres Eigenschaftsprofils optimiert werden.

Es sind aber auch Gleitlager mit sogenannten Gradientenschichten bekannt. Dabei wird eine Eigenschaft, insbesondere die Härte der Schicht, über die Schichtdicke variiert. In der Regel erfolgt dies über die Ausbildung von Konzentrationsgradienten für einen Legierungsbestandteil. Es kann damit beispielsweise über Schichtdicke des Gleitlagers die Ausscheidung von unterschiedlichen Mischphasen bzw. intermetallischen Verbindungen erreicht werden, die wiederum zu unterschiedlichen Härten innerhalb der Gleitschicht führen. Nachteilig ist dabei aber vor allem, dass intermetallische Verbindungen in der Regel spröde sind und damit eine Gefahr für den Bruch der Gleitschicht darstellen. WO 2010/005983 und EP1705259A1 beschreiben Gleitlagerelemente des Standes der Technik.

Der vorliegenden Erfindung liegt die Aufgabe zugrunde, ein Gleitlagerelement bzw. ein Verfahren zu dessen Herstellung anzugeben, das den voranstehend genannten Anforderungen an die höhere Leistungsdichte eines Motors bzw. eines Triebwerks gerecht wird.

Die Aufgabe der Erfindung wird bei dem eingangs genannten Gleitlagerelement dadurch gelöst, dass sich die Mikrostruktur über die Gleitschichtdicke von einem globularen Habitus der Körner im Bereich einer der Stützschicht näheren zweiten Oberfläche der Gleitschicht in einen zumindest annähernd stengeligen Habitus mit einer Längserstreckung der Körner im Bereich einer der Stützschicht entfernteren ersten Oberfläche der Gleitschicht ändert.

Weiter wird die Aufgabe der Erfindung mit dem eingangs genannten Verfahren gelöst, bei dem die Temperatur während der Herstellung der Gleitschicht verändert wird, und dadurch die Mikrostruktur über die Gleitschichtdicke von einem globularen Habitus der Körner im Bereich einer der Stützschicht näheren zweiten Oberfläche der Gleitschicht in einen zumindest annähernd stengeligen Habitus mit einer Längserstreckung der Körner im Bereich einer der Stützschicht entfernteren ersten Oberfläche der Gleitschicht verändert wird.

Von Vorteil ist dabei, dass die Gleitschicht relativ einfach aus nur einem einzelnen Metall - die maximal 1 Gew.-% weitere Metalle sind übliche Verunreinigungen von Silber - hergestellt werden kann, und diese Gleitschicht trotzdem ein gutes Einlaufverhalten zeigt. Die Gleitschicht kann daher sowohl als Einlaufschicht zum Beginn des Betriebes des Gleitlagers als auch als Gleitschicht an sich nach der Einlaufphase während des normalen Gleitlagerbetriebes dienen. Der Aufbau aus nur einem Metall eliminiert die Bildung von intermetallischen Phasen. Durch die zusätzliche Funktionalität "Einlaufschicht" der Gleitschicht entfällt die Notwendigkeit einer zusätzlich für diesen Zweck aufzubringenden Schicht, wodurch das Gleitlagerelement relativ einfach aufgebaut ist und dementsprechend das Verfahren zur Herstellung des Gleitlagerelementes einfacher gestaltet werden kann. Andererseits ist die Gleitschicht durch die globularen Körner auch entsprechend hart, wodurch sie die hohen Anforderungen an die Verschleißbeständigkeit in Motoren bzw. Triebwerken erfüllten kann. Mit anderen Worten ausgedrückt weist die Gleitschicht im Bereich einer Oberfläche eine entsprechende Einbettfähigkeit für Schmutzpartikel auf, und auf der anderen Oberfläche die geforderte Dauerfestigkeit, obwohl sie nur aus einem einzigen Metall oder aus einer Legierung mit maximal 5 Gew.-% zumindest eines weiteren Metalls besteht.

Nach einer Ausführungsvariante dazu kann die Gleitschicht eine Gleitschichtdicke zwischen 10 µm und 100 µm aufweisen. Unterhalb von 10 µm ist es schwierig, die Bifunktionalität der Gleitschicht noch in ausreichendem Ausmaß abzubilden. Anderseits bringt eine weitere Erhöhung der Gleitschichtdicke über 100 µm hinaus keine wesentliche Verbesserung hinsichtlich Langzeitstabilität mehr.

Nach einer weiteren Ausführungsvariante des Gleitlagerelementes kann vorgesehen sein, dass die stengelige Mikrostruktur von der ersten Oberfläche der Gleitschicht bis in eine Tiefe der Gleitschicht von mindestens 10 % und maximal 95 % reicht. Es wird damit erreicht, dass das Gleitlagerelement über einen relativ langen Zeitraum seine Eigenschaften der Gleitfähigkeit und Einbettfähigkeit für Schmutzpartikel behält. Bei weniger als 10 % Schichtdicke des globularen Anteils der Körner erfährt die darüber ausgebildete weichere Schicht aus den stengeligen Körnern keine ausreichende Unterstützung mehr. Andererseits wird die Gleitschicht bei mehr als 95 % Schichtdicke des globularen Anteils der Körner schon relativ hart, wodurch nach der Einlaufphase bereits innerhalb kurzer Zeit die voranstehend genannten Eigenschaften reduziert sind.

Es kann weiter vorgesehen sein, dass die Gleitschicht direkt auf der Stützmetallschicht angeordnet und mit dieser verbunden ist, wodurch die Stützwirkung für die stengeligen Körner durch die globularen Körner unmittelbar mit der Stützmetallschicht verbessert werden kann. Es kann damit in weiterer Folge einer dickeren Teilschicht mit den Körnern mit dem stengeligen Habitus eine längere Standzeit verliehen werden. Darüber hinaus bewirkt die direkte Anordnung dieser Gleitschicht auf der Stützschicht auch eine Verfahrensvereinfachung durch die Reduktion der Verfahrensschritte zur Ausbildung des Schichtaufbaus des Gleitlagerelementes.

Zur weiteren Verbesserung der voranstehend genannten Effekte bezüglich Einlauf- und Laufverhalten im Normalbetrieb der Gleitschicht ist es von Vorteil, wenn die Körner mit dem stengeligen Habitus mit ihrer Längserstreckung zumindest annähernd senkreckt auf die ersten Oberfläche der Gleitschicht orientiert sind oder die Längsachsen der Körner um maximal 30 ° von dieser senkrechten Orientierung abweichen.

Eine Verbesserung der voranstehend genannten Effekte bezüglich Einlauf- und Laufverhalten im Normalbetrieb der Gleitschicht konnte auch beobachtet werden, wenn die Längserstreckungen der Körner mit der stengeligen Mikrostruktur mindestens dem zweifachen der Breitenerstreckung der Körner mit der stengeligen Mikrostruktur entspricht. Mit dieser Ausgestaltung können sich die Körner mit dem stengeligen Habitus in Umfangsrichtung und in axialer Richtung des Gleitlagerelementes besser gegenseitig abstützen.

Zur Ausbildung einer verbesserten Bindezone zwischen der Stützschicht und der Gleitschicht bzw. zwischen letzterer und der darunter angeordneten Schicht des Gleitlagerelementes kann vorgesehen werden, dass ein mittlerer Durchmesser der Körner mit dem globularen Habitus maximal 20 % der Länge in der Längserstreckung der Körner mit dem stengeligen Habitus beträgt. Durch die feineren Körner kann zudem der Gleitschichtbereich mit den globularen Körnern eine höhere Härte und damit ein besseres Langzeitverhalten hinsichtlich Festigkeit und Verschleißfestigkeit aufweisen.

Nach einer Ausführungsvariante des Verfahrens kann vorgesehen sein, dass die Temperatur während der Herstellung der Gleitschicht erhöht wird. Es kann damit die Ausbildung des gewünschten Gefüges einfacher erhalten werden.

Zum besseren Verständnis der Erfindung wird diese anhand der nachfolgenden Figuren näher erläutert.

Es zeigen jeweils in stark vereinfachter, schematischer Darstellung:
- Fig. 1: ein Gleitlagerelement in Form einer Gleitlagerhalbschale in Seitenansicht;
- Fig. 2: eine schematische Darstellung der Änderung des Mikrogefüges der Gleitschicht über deren Schichtdicke.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

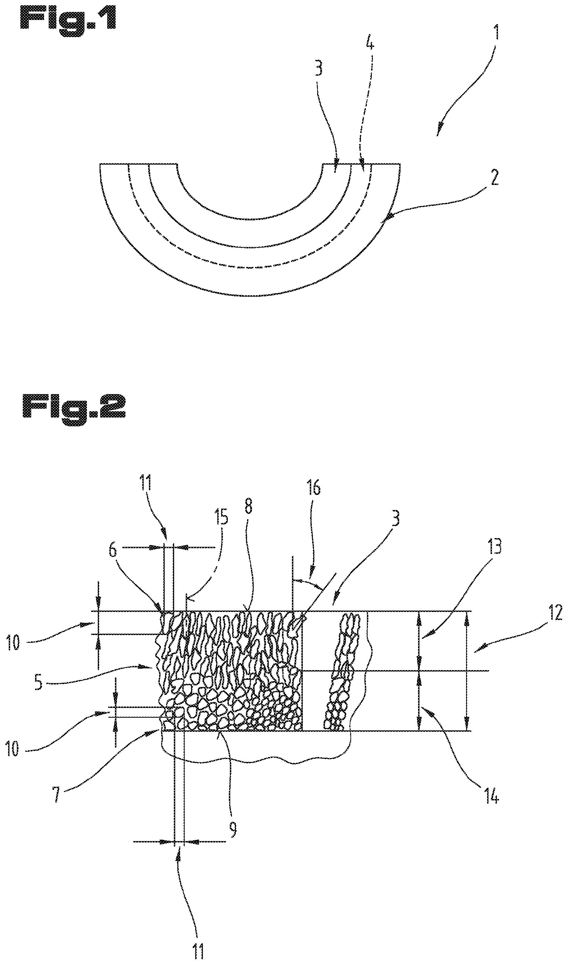

Fig. 1 zeigt ein mehrschichtiges Gleitlagerelement 1 (Mehrschichtgleitlager) in Form einer Gleitlagerhalbschale in Seitenansicht. Dargestellt ist die bevorzugte zweischichtige Ausführungsform dieses Gleitlagerelements 1, bestehend aus einer metallischen Stützschicht 2 und einer unmittelbar auf der Stützschicht 2 angeordneten Gleitschicht 3 bildet. Die Gleitschicht 3 ist dabei jene Schicht, auf der das zu lagernden Bauteil abgleitet.

Es sei erwähnt, dass weitere Schichten angeordnet werden können, also beispielsweise eine Lagermetallschicht 4 zwischen der Gleitschicht 3 und der Stützschicht 2, wie dies als dreischichtige Variante in Fig. 1 strichliert dargestellt ist, bei der die Lagermetallschicht 4 direkt auf der Stützschicht 2 und die Gleitschicht 3 direkt auf der Lagermetallschicht 4 aufgebracht ist. Ebenso kann zwischen der Gleitschicht 3 und der Lagermetallschicht 4 und/oder zwischen der Stützschicht 2 und der Gleitschicht 3 oder der Lagermetallschicht 4 eine Haftmittelschicht und/oder eine Diffusionssperrschicht oder auf der Gleitschicht 3 eine Einlaufschicht angeordnet sein. Weiter kann auf der Rückseite der Stützschicht 2 eine Antifrettingschicht angeordnet sein.

Das Gleitlagerelement 1 kann auch anders als Fig. 1 dargestellt ausgeführt sein, beispielsweise als Lagerbuchse. Ebenso sind Ausführungen wie Anlaufringe, axial laufende Gleitschuhe, oder dergleichen möglich. Es sind auch Gleitlagerelemente 1 möglich, die einen von 180 ° abweichenden Winkelbereich überdecken. Die Stützschicht 2 kann gegebenenfalls auch ein Pleuel sein, dessen Auge mit der Gleitschicht 3 direkt beschichtet ist. Generell kann die Gleitschicht 3 zur Ausbildung des Gleitlagerelementes 1 direkt auf ein Bauteil aufgebracht werden, wie beispielsweise auf ein Zahnrad für ein Flugzeugtriebwerk. Das Gleitlagerelement 1 ist also nicht ein herkömmliches Gleitlager in engerem Sinn, also beispielsweise im Sinne von einer Gleitlagerhalbschale. Vielmehr ist unter einem Gleitlagerelement 1 ein Element zu verstehen, das die Gleitschicht 3 aufweist. Bei Direktbeschichtungen wird dabei das Element selbst zur Stützschicht 2.

Die Stützschicht 2 besteht aus einem Werkstoff, welche dem Gleitlagerelement 1 die erforderliche Strukturfestigkeit verleiht. In der bevorzugten Ausführungsvariante des Gleitlagerelements 1 besteht sie jedoch aus einem Stahl.

Sollte eine Lagermetallschicht 4 angeordnet sein, können hierfür unterschiedlichste, aus dem einschlägigen Stand der Technik bekannte Legierungen eingesetzt werden. Bevorzugt besteht die Lagermetallschicht 4 aber aus einer Bronze, insbesondere einer Bleibronze.

Die Lagermetallschicht 4 kann mit einem herkömmlichen, aus der Gleitlagertechnik bekannten Verfahren auf der Stützschicht 2 abgeschieden bzw. angeordnet werden. Beispielsweise kann ein Bimetall aus der Stützschicht 2 und der Lagermetallschicht 3 durch Aufwalzen der Lagermetallschicht 3 hergestellt werden. Ebenso kann die Lagermetallschicht 4 auf die Stützschicht 2 aufgegossen werden. Gegebenenfalls wird dieses Bimetall umgeformt und/oder spanabhebend bearbeitet.

Falls eine Haftvermittlerschicht oder eine Diffusionssperrschicht vorhanden ist, kann diese aus den herkömmlichen, bekannten Werkstoffen hierfür bestehen.

Die Gleitschicht 3 besteht zu 100 Gew.-% aus Silber oder aus Silber, das gegebenenfalls bis zu 5 Gew.-%, insbesondere zwischen 0,01 Gew.-% bis 5 Gew.-%, zumindest eines weiteren Metalls und gegebenenfalls übliche Verunreinigungen aufweisen kann. Die Gleitschicht 3 besteht also, abgesehen von den Verunreinigungen, entweder aus einem einzigen Metall, nämlich Reinsilber oder Reinstsilber, oder aus einer Silberlegierung. Als weiteres Metall kommt zumindest ein Metall ausgewählt aus einer Gruppe umfassend oder bestehend aus Cu, Sb, Mo, Co in Betracht.

Wie jedes Metall weist auch das Silber der Gleitschicht 3 eine Mikrostruktur 5 auf, die geprägt ist durch die Art der Vorbehandlung bzw. des Abscheideverfahrens. Die Mikrostruktur 5 der Gleitschicht 3 ist schematisch in Fig. 2 wiedergegeben.

In dieser Mikrostruktur 5 sind erste Körner 6 und zweite Körner 7 ausgebildet, die über die Korngrenzen aneinander anliegen.

Die ersten Körner 6 sind anschließend an eine erste Oberfläche 8 der Gleitschicht 3 angeordnet bzw. ausgebildet. Die zweiten Körner 7 sind anschließend an eine zweite Oberfläche 9 der Gleitschicht 3 angeordnet bzw. ausgebildet. Die zweite Oberfläche 9 ist dabei jene Oberfläche der Gleitschicht 3, die der Stützschicht 2 näher liegt. In der bevorzugten Ausführungsvariante des Gleitlagerelementes 1 liegt die Gleitschicht 3 über die zweite Oberfläche 9 an der Stützschicht 2 an. Somit ist die erste Oberfläche 9 jene Oberfläche der beiden Oberflächen des Gleitlagerelementes 1, die von der Stützschicht 2 weiter entfernt ist. Insbesondere gleitet ein zu lagerndes Bauteil an dieser zweiten Oberfläche 9 ab. Die zweite Oberfläche 9 ist also bei einer Ausbildung des Gleitlagerelementes 1 als Halbschale oder als Buchse die radial innere Oberfläche und die erste Oberfläche 8 die radial äußere Oberfläche der Gleitschicht 3.

Die ersten Körner 6 haben einen stengeligen Habitus. Dieser stengelige Habitus kann auch als zumindest annähernd säulenförmiger Habitus bezeichnet werden.

Ein Korn 6 weist im Sinne der Erfindung einen stengeligen Habitus auf, wenn eine Längserstreckung 10 des Korns 6 zumindest das 1,5-fache einer Breitenerstreckung 11 des Korns 6 beträgt.

Zum Unterschied zu den ersten Körnern 6 weisen die zweiten Körner 7 einen globularen Habitus auf.

Ein Korn 7 weist im Sinne der Erfindung einen globularen Habitus auf, wenn die Längserstreckung 10 des Korns 7 weniger das 1,5-fache, insbesondere weniger als das 1,3 fache, der Breitenerstreckung 11 des Korns 7 beträgt. ein globulares Korn 7 kann also zumindest annähernd kugelförmig sein.

Die Gleitschicht 3 weist eine gesamte Gleitschichtdicke 12 von der ersten Oberfläche 8 zur zweiten Oberfläche 9 auf. In der bevorzugten Ausführungsvariante ist die Gleitschichtdicke 12 ausgewählt aus einem Bereich mit einer unteren Grenze von 10 µm, insbesondere 15 µm, und einer oberen Grenze von 100 µm.

Die ersten Körner 6 sind von der ersten Oberfläche 8 in Richtung auf die zweite Oberfläche 9 der Gleitschicht bis in eine erste Tiefe 13 der Gleitschicht 9 ausgebildet bzw. angeordnet und die zweiten Körner 7 sind von der zweiten Oberfläche 9 in Richtung auf die erste Oberfläche 8 der Gleitschicht bis in eine zweite Tiefe 14 der Gleitschicht 9. Die erste Tiefe 13 und die zweite Tiefe 14 ergeben in Summe die gesamte Gleitschichtdicke 12. Somit ändert sich der stengelförmige Habitus der ersten Körner 6 innerhalb der Gleitschicht 3 zum globularen Habitus der zweiten Körner 7.

Es sei an dieser Stelle darauf hingewiesen, dass es zwar bevorzugt ist, wenn die ersten Körner 6 ausschließlich den stengelförmigen Habitus und die zweiten Körner 7 ausschließlich den globularen Habitus aufweisen. Es sind aber Ausführungsvarianten der Gleitschicht 3 möglich, bei denen die ersten Körner 6 überwiegend den stengelförmigen Habitus und die zweiten Körner 7 überwiegend de globularen Habitus aufweisen. Mit dem Ausdruck "überwiegend" ist dabei gemeint, dass ein Anteil von zumindest 80 %, insbesondere zumindest 90 %, der ersten Körner 6 den stengelförmigen Habitus aufweisen, bezogen auf die Gesamtheit der ersten Körner 6 in dem Volumen der Gleitschicht 3, das durch die erste Oberfläche 8 und die erste Tiefe 13 der Gleitschichtschichtdicke 12 definiert ist, und ein Anteil von zumindest 80 %, insbesondere zumindest 90 %, der zweiten Körner 7 den globularen Habitus aufweisen, bezogen auf die Gesamtheit der zweiten Körner 7 in dem Volumen der Gleitschicht 3, das durch die erste Oberfläche 8 und die zweite Tiefe 13 der Gleitschichtschichtdicke 12 definiert ist.

Hergestellt werden kann dieser Wechsel in der Mikrostruktur der Gleitschicht 3 in dem während der Herstellung bzw. Abscheidung der Gleitschicht 3 die Temperatur verändert wird. Die Gleitschicht 3 wird mittels eines PVD-Verfahrens, insbesondere durch Kathodensputtern, hergestellt bzw. auf der unter der Gleitschicht 3 angeordneten Stützschicht abgeschieden. Dazu wird die Temperatur während der Herstellung bzw. Abscheidung der Gleitschicht 3 um einen Wert erhöht, der ausgewählt ist aus einem Bereich von 10 °C bis 50 °C.

Nach einer Ausführungsvariante des Gleitlagerelementes 1 kann vorgesehen sein, dass die stengelige Mikrostruktur der Gleitschicht 3 von der ersten Oberfläche 8 der Gleitschicht 3 bis in eine Tiefe 13 der Gleitschicht 3 von mindestens 10 %, insbesondere mindestens 20 %, und maximal 95 %, insbesondere maximal 75 %, reicht. Dies kann über eine entsprechende Temperaturführung, insbesondere im angegebenen Bereich der Temperaturänderung, erreicht werden.

Es ist weiter bevorzugt, wenn die ersten Körner 6 mit dem stengeligen Habitus mit ihrer Längserstreckung 10 zumindest annähernd senkreckt auf die erste Oberfläche 8 der Gleitschicht 3 orientiert sind, wie dies im linken Teil der Fig. 2 dargestellt ist, oder wenn Längsachsen 15 der ersten Körner 6 um einen Winkel 16 von maximal 30 °, insbesondere maximal 20 °, bevorzugt maximal 10 °, von dieser senkrechten Orientierung abweichen. Dies kann ebenfalls über eine entsprechende Temperaturführung, insbesondere im angegebenen Bereich der Temperaturänderung, erreicht werden.

Wie bereits voranstehend ausgeführt, werden unter stengeligen ersten Körnern 6 Körner verstanden, bei denen die Längserstreckung 10 zumindest das 1,5-fache der Breitenerstreckung 11 beträgt. Bevorzugt wird aber eine Ausführungsvariante des Gleitlagerelementes 1, bei dem die stengeligen ersten Körner 6 eine Längserstreckung 10 aufweisen, die zumindest dem zweifachen, insbesondere zumindest dem dreifachen, vorzugsweise zumindest dem vierfachen, der Breitenerstreckung beträgt. Auch diese Ausführungsvariante des Gleitlagerelementes 1 kann durch eine entsprechende Temperaturführung, insbesondere im angegebenen Bereich der Temperaturänderung, erreicht werden.

Ein mittlerer Durchmesser der zweiten Körner 7 mit dem globularen Habitus kann vorzugsweise maximal 20 % der Länge in der Längserstreckung 10 der ersten Körner 6 mit dem stengeligen Habitus betragen. Dies kann durch die entsprechende Wahl der Temperatur zum Beginn der Abscheidung der Gleitschicht erhalten werden. Die Länge der stengeligen Körner 6 kann beispielsweise zwischen 4 µm und 80 µm betragen.

Es sei darauf hingewiesen, dass unter der Längserstreckung 10 der ersten Körner 6 jene Richtung verstanden wird, in der das jeweilige erste Korn seine größte Länge aufweist. Dementsprechend wird unter der Breitenerstreckung 11 jene Richtung verstanden, die senkrecht auf die Längserstreckung 10 steht. Es wird dabei die größte Abmessung in dieser Richtung des jeweiligen Korns betrachtet.

Sofern im Voranstehenden ein Relativbezug auf die Längserstreckung 10 der ersten Körner 6 vorgenommen wurde, ist dabei eine mittlere Längserstreckung gemeint, die sich als arithmetisches Mittel aus der Längserstreckung 10, d.h. der Länge, von zwanzig Einzelkörnern mit stengeligem Habitus errechnet.

Unter dem mittleren Durchmesser der zweiten Körner 7 mit dem globularen Habitus wird das arithmetische Mittel von zwanzig Einzelwerten des Durchmessers der das jeweilige betrachtete Korn 7 gerade vollständig einhüllenden Kugel verstanden.

Der Übergang zwischen dem globularen und dem stengelförmigen Habitus der Mikrostruktur der Gleitschicht 3 kann sprungförmig ausgebildet sein. Damit ändert sich auch die Härte der Gleitschicht 3 sprungartig von hart an der zweiten Oberfläche 9 zu im Vergleich dazu weich an der ersten Oberfläche 8. Vorzugsweise wird jedoch über den Querschnitt in Richtung der Gleitschichtdicke 12 betrachtet ein Härtegradient ausgebildet, indem sich der Habitus der ersten Körner 6 gradientenförmig zum Habitus der zweiten Körner 7 ändert. Es kann dabei vorgesehen werden, dass im Bereich der zweiten Oberfläche 7, also am Beginn der Abscheidung der Gleitschicht 3, die zweiten Körner 7 mit dem kleinsten Durchmesser abgeschieden werden. Durch Temperaturerhöhung während der Abscheidung der Gleitschicht 3 kann erreicht werden, dass die zweiten Körner 7, die auf den zuerst abgeschiedenen Körnern 7 abgeschieden bzw. ausgebildet werden mit einem im Vergleich dazu größeren Durchmesser abgeschieden bzw. ausgebildet werden. Mit dem Fortschreiten des Abscheideverfahrens der Gleitschicht 3 werden durch weitere Temperaturerhöhung die zweiten Körner 7 im größer, bis sie in den stengeligen Habitus der ersten Körner 6 wechseln. Durch weitere Temperaturerhöhung werden die ersten Körner 6 mit immer größerer Längserstreckung 10 abgeschieden bzw. ausgebildet, bis sie an der ersten Oberfläche ihre größte Längserstreckung erreichen. Das Ergebnis dieses Verfahrens ist im rechten Teil der Fig. 2 schematisch dargestellt.

Es sei darauf hingewiesen, dass es im Rahmen dieses Verfahrens vorkommen, kann, dass beispielsweise unter den ersten Körnern 6 mit der größten Längserstreckung auch eine Minderheit erste Körner 6 zu finden sind, die im Vergleich dazu eine geringere Längserstreckung 10 aufweisen. Dies ist im Rahmen dieses Verfahrens aber mitumfasst, solange über den Querschnitt der Gleitschichtdicke 12 ein Härtegradient, insbesondere mit einer kontinuierlich abnehmenden Härte, ausgebildet wird.

Zur Evaluierung des Gleitlagerelementes wurden u.a. folgende Ausführungsbeispiele angefertigt. Es wurden dazu unter den nachfolgenden Bedingungen auf zu Halbschalen umgeformten Stützschichten 2 aus Stahl jeweils mittels DC-Magnetronsputtern Gleitschichten 3 aus Reinsilber abgeschieden.

| Ausführungsbeispiel | | A | B | C |
|---|---|---|---|---|
| Substrattemperatur zu Beginn der Beschichtung | °C | 210 | 230 | 165 |
| Substrattemperatur am Ende der Beschichtung | °C | 220 | 260 | 200 |
| mittlere Beschichtungsrate | µm/min | 1,65 | 0,48 | 1,97 |
| Prozessgas | - | Ar | Kr | Ar |
| Prozessgasdruck | Pa | 0,7 | 2,3 | 6,0 |
| Spannung am Substrat | V | -40 | -50 | 0 |
| Spannung am Target | V | -532 | -440 | -580 |
| Schichthärte an Oberfläche | HV0,005 | 116 | 104 | 133 |
| Schichthärte an Bindezone | HV0,005 | 132 | 162 | 154 |
| Dicke des globularen Bereiches | µm | 42 | 12 | 8 |
| Dicke des stengeligen Bereiches | µm | 38 | 23 | 70 |

Ähnliche Ergebnisse der Relation der Härtewerte an der Oberfläche und der Bindezone werden erreicht, wenn anstelle von Reinsilber eine Silberlegierung hergestellt wird, die einen Anteil von maximal 5 Gew.-% zumindest eines der Elemente Cu, Sb, Mo, Co aufweist. Es wird daher auf die Wiedergabe dieser Ergebnisse verzichtet.

Der Prozessgasdruck kann generell ausgewählt werden aus einem Bereich von 0,3 Pa bis 10 Pa. Gegebenenfalls ist es auch möglich, den Habitus der Körner der Gleitschicht über die Änderung des Prozessgasdrucks während der Abscheidung, insbesondere zusammen mit der Temperaturänderung, zu verändern.

Als Prozessgase wird vorzugsweise zumindest eines der Gase Argon oder Krypton eingesetzt. Es können aber auch andere Gase, insbesondere inerte Gase verwendet werden.

Die Ausführungsbeispiele zeigen bzw. beschreiben mögliche Ausführungsvarianten des Gleitlagerelements 1, wobei an dieser Stelle bemerkt sei, dass auch diverse Kombinationen der einzelnen Ausführungsvarianten untereinander möglich sind.

Der Ordnung halber sei abschließend darauf hingewiesen, dass zum besseren Verständnis des Aufbaus des Gleitlagerelements 1 dieses bzw. dessen Bestandteile teilweise unmaßstäblich und/oder vergrößert und/oder verkleinert dargestellt wurden.

### Bezugszeichenaufstellung

- 1: Gleitlagerelement
- 2: Stützschicht
- 3: Gleitschicht
- 4: Lagermetallschicht
- 5: Mikrostruktur
- 6: Korn
- 7: Korn
- 8: Oberfläche
- 9: Oberfläche
- 10: Längserstreckung
- 11: Breitenerstreckung
- 12: Gleitschichtdicke
- 13: Tiefe
- 14: Tiefe
- 15: Längsachse
- 16: Winkel

## Patentansprüche

1. Gleitlagerelement (1) umfassend eine Stützschicht (2) und eine Gleitschicht (3), wobei die Gleitschicht (3) aus Silber oder aus Silber mit einem Maximalgehalt an weiteren Metallen von 5 Gew.-%, ausgewählt aus einer Gruppe bestehend aus Cu, Sb, Mo, Co, besteht, wobei die Gleitschicht (3) eine Mikrostruktur mit Körnern (6, 7) aufweist und eine Gleitschichtdicke (12) hat, **dadurch gekennzeichnet, dass** sich die Mikrostruktur über die Gleitschichtdicke (12) von einem globularen Habitus der Körner (7) im Bereich einer der Stützschicht (2) näheren zweiten Oberfläche (9) der Gleitschicht (3) in einen zumindest annähernd stengeligen Habitus mit einer Längserstreckung (10) der Körner (7) im Bereich einer der Stützschicht (2) entfernteren ersten Oberfläche (8) der Gleitschicht (3) ändert.

2. Gleitlagerelement nach einem der Ansprüche 1, **dadurch gekennzeichnet, dass** die Gleitschicht (3) eine Gleitschichtdicke (12) zwischen 10 µm und 100 µm aufweist.

3. Gleitlagerelement (1) nach Anspruch 1 oder 2, **dadurch gekennzeichnet, dass** die stengelige Mikrostruktur von der ersten Oberfläche (8) der Gleitschicht (3) bis in eine Tiefe (13) der Gleitschicht (3) von mindestens 10 % und maximal 95 % der gesamten Gleitschichtdicke (12) reicht.

4. Gleitlagerelement (1) nach einem der Ansprüche 1 bis 3, **dadurch gekennzeichnet, dass** die Gleitschicht (3) direkt auf der Stützschicht (2) angeordnet und mit dieser verbunden ist.

5. Gleitlagerelement (1) nach einem der Ansprüche 1 bis 4, **dadurch gekennzeichnet, dass** die Körner (6) mit dem stengeligen Habitus mit ihrer Längserstreckung (10) zumindest annähernd senkreckt auf die erste Oberfläche (8) der Gleitschicht (3) orientiert sind oder Längsachsen (15) der Körner (6) um maximal 30 ° von dieser senkrechten Orientierung abweichen.

6. Gleitlagerelement (1) nach einem der Ansprüche 1 bis 5, **dadurch gekennzeichnet, dass** die Längserstreckungen (10) der Körner (6) mit der stengeligen Mikrostruktur mindestens dem zweifachen der Breitenerstreckung (11) der Körner (6) mit der stengeligen Mikrostruktur entspricht.

7. Gleitlagerelement (1) nach einem der Ansprüche 1 bis 6, **dadurch gekennzeichnet, dass** ein mittlerer Durchmesser der Körner (7) mit dem globularen Habitus maximal 20 % der Länge in der Längserstreckung (10) der Körner (6) mit dem stengeligen Habitus beträgt.

8. Verfahren zur Herstellung eines Gleitlagerelements (1) umfassend eine Stützschicht (2) und eine, eine Mikrostruktur mit Körnern (6, 7) aufweisende Gleitschicht (3), wobei die Gleitschicht (3) mit einer Gleitschichtdicke (12) aus Silber oder aus Silber mit einem Maximalgehalt an weiteren Metallen von 5 Gew.-%, ausgewählt aus einer Gruppe bestehend aus Cu, Sb, Mo, Co, mittels eines PVD-Verfahrens hergestellt wird, **dadurch gekennzeichnet, dass** die Temperatur während der Herstellung der Gleitschicht (3) um einen Wert erhöht wird, der ausgewählt ist aus einem Bereich von 10 °C bis 50 °C, und dadurch die Mikrostruktur über die Gleitschichtdicke (12) von einem globularen Habitus der Körner (7) im Bereich einer der Stützschicht (2) näheren zweiten Oberfläche (9) der Gleitschicht (3) in einen zumindest annähernd stengeligen Habitus mit einer Längserstreckung (10) der Körner (6) im Bereich einer der Stützschicht (2) entfernteren ersten Oberfläche (8) der Gleitschicht (3) verändert wird.

## Claims

1. A sliding bearing element (1) comprising a supporting layer (2) and a sliding layer (3), wherein the sliding layer (3) is made of silver or silver with a maximum content of other metals of 5 % by weight, selected from a group consisting of Cu, Sb, Mo, Co, and wherein the sliding layer (3) has a microstructure with grains (6, 7) and a sliding layer thickness (12), **characterized in that** the microstructure across the sliding layer thickness (12) changes from a globular habitus of the grains (7) in the region of a second surface (9) of the sliding layer (3), which lies closer to the supporting layer (2), to an at least approximately columnar habitus with a longitudinal extent (10) of the grains (7) in the region of a first surface (8) of the sliding layer (3), which lies farther away from the supporting layer (2).

2. The sliding bearing element according to claim 1, **characterized in that** the sliding layer (3) has a sliding layer thickness (12) between 10 µm and 100 µm.

3. The sliding bearing element (1) according to claim 1 or 2, **characterized in that** the columnar microstructure extends from the first surface (8) of the sliding layer (3) up to a depth (13) of the sliding layer (3), which corresponds to at least 10 % and no more than 95 % of the total sliding layer thickness (12).

4. The sliding bearing element (1) according to one of claims 1 to 3, **characterized in that** the sliding layer (3) is arranged directly on the supporting layer (2) and connected thereto.

5. The sliding bearing element (1) according to one of claims 1 to 4, **characterized in that** the longitudinal extent (10) of the grains (6) with the columnar habitus is at least approximately oriented perpendicular to the first surface (8) of the sliding layer (3) or longitudinal axes (15) of the grains (6) deviate from this perpendicular orientation by no more than 30 °.

6. The sliding bearing element (1) according to one of claims 1 to 5, **characterized in that** the longitudinal extent (10) of the grains (6) with the columnar microstructure corresponds to at least twice the lateral extent (11) of the grains (6) with the columnar microstructure.

7. The sliding bearing element (1) according to one of claims 1 to 6, **characterized in that** an average diameter of the grains (7) with the globular habitus amounts to no more than 20 % of the length in the longitudinal extent (10) of the grains (6) with the columnar habitus.

8. A method for producing a sliding bearing element (1) comprising a supporting layer (2) and a sliding layer (3), which has a microstructure with grains (6, 7), wherein said sliding layer (3) is made of silver or silver with a maximum content of other metals of 5 % by weight, selected from a group consisting of Cu, Sb, Mo, Co, and produced with a sliding layer thickness (12) by means of a PVD process, **characterized in that** the temperature is during the production of the sliding layer (3) increased by a value, which is selected from a range of 10 °C to 50 °C, and the microstructure across the sliding layer thickness (12) is thereby changed from a globular habitus of the grains (7) in the region of a second surface (9) of the sliding layer (3), which lies closer to the supporting layer (2), to an at least approximately columnar habitus with a longitudinal extent (10) of the grains (6) in the region of a first surface (8) of the sliding layer (3), which lies farther away from the supporting layer (2).

## Revendications

1. Elément de palier lisse (1) comprenant une couche de protection (2) et une couche de glissement (3), la couche de glissement (3) étant constituée d'argent, ou d'argent avec une teneur maximale en d'autres métaux de 5 % en poids, choisis dans un groupe consistant en Cu, Sb, Mo, Co, la couche de glissement (3) présentant une microstructure à grains (6, 7), et ayant une épaisseur (12) de couche de glissement, **caractérisé en ce que** la microstructure change, sur l'épaisseur (12) de la couche de glissement, d'un habitus globulaire des grains (7) dans la zone d'une deuxième surface (9), plus proche de la couche de protection (2), de la couche glissement (3), en un habitus au moins approximativement colonnaire, ayant une extension longitudinale (10) des grains (7) dans la zone d'une première surface (8), plus opposée à la couche de protection (2), de la couche de glissement (3).

2. Elément de palier lisse selon l'une des revendications 1, **caractérisé en ce que** la couche de glissement (3) présente une épaisseur (12) de la couche de glissement comprise entre 10 µm et 100 µm.

3. Elément de palier lisse (1) selon la revendication 1 ou 2, **caractérisé en ce que** la microstructure colonnaire s'étend de la première surface (8) de la couche de glissement (3) jusqu'à une profondeur (13) de la couche de glissement (3) égale à au moins 10 % et au maximum à 95 % de l'épaisseur totale (12) de la couche de glissement.

4. Elément de palier lisse (1) selon l'une des revendications 1 à 3, **caractérisé en ce que** la couche de glissement (3) est directement disposée sur la couche de protection (2) et est reliée à cette dernière.

5. Elément de palier lisse (1) selon l'une des revendications 1 à 4, **caractérisé en ce que** les grains (6) ayant l'habitat colonnaire sont, par leur extension longitudinale (10), orientés d'une manière au moins approximativement perpendiculaire à la première surface (8) de la couche de glissement (3), ou **en ce que** les axes longitudinaux (15) des grains (6) s'écartent au maximum de 30° de cette orientation perpendiculaire.

6. Elément de palier lisse (1) selon l'une des revendications 1 à 5, **caractérisé en ce que** l'extension longitudinale (10) des grains (6) ayant la microstructure colonnaire correspond au moins au double de l'extension en largeur (11) des grains (6) ayant la structure colonnaire.

7. Elément de palier lisse (1) selon l'une des revendications 1 à 6, **caractérisé en ce qu'**un diamètre moyen des grains (7) ayant l'habitus globulaire est au maximum de 20 % de la longueur dans l'extension longitudinale (10) des grains (6) ayant l'habitus colonnaire.

8. Procédé de fabrication d'un élément de palier lisse (1) comprenant une couche de protection (2) et une couche de glissement (3) présentant une microstructure à grains (6, 7), la couche de glissement (3) étant fabriquée par un procédé PVD avec une épaisseur (12) de la couche de glissement, à partir d'argent ou d'argent avec une teneur maximale en autres métaux de 5 % en poids, choisis dans un groupe consistant en Cu, Sb, Mo, Co, **caractérisé en ce qu'**on élève la température pendant la fabrication de la couche de glissement (3) d'une valeur qui est choisie dans une plage de 10 °C à 50 °C, et **en ce que** la microstructure change, sur l'épaisseur (12) de la couche de glissement, d'un habitus globulaire des grains (7) dans la zone d'une deuxième surface (9), plus proche de la couche de protection (2), de la couche de glissement (3), en un habitus au moins approximativement colonnaire, ayant une extension longitudinale (10) des grains (6) dans la zone d'une première surface (8), plus éloignée de la couche de protection (2), de la couche de glissement (3).
